# EUROPÄISCHE PATENTSCHRIFT

(11) **EP 3 072 370 B1**
(45) Veröffentlichungstag und Bekanntmachung des Hinweises auf die Patenterteilung: **18.10.2017**
(21) Anmeldenummer: 14786668.5
(22) Anmeldetag: 21.10.2014
(51) Int. Cl.: H05K 1/02, H01L 23/498, H01L 23/552

(54) **MEHRFUNKTIONALE HOCHSTROMLEITERPLATTE**
MULTIFUNCTIONAL PRINTED CIRCUIT BOARD
CIRCUIT IMPRIMÉ MULTIFONCTIONNEL

(30) Priorität: 21.11.2013 DE 102013223761; 22.11.2013 DE 102013223888
(43) Veröffentlichungstag der Anmeldung: 28.09.2016
(73) Patentinhaber: ZF Friedrichshafen AG, 88046 Friedrichshafen (DE)
(72) Erfinder: LASSMANN, Wilfried, 92242 Hirschau (DE); SPERBER, Michael, 92259 Neukirchen (DE)
(86) Internationale Anmeldenummer: PCT/EP2014/072479
(87) Internationale Veröffentlichungsnummer: WO 2015/074814

(56) Entgegenhaltungen:
- WO-A1-03/073812
- DE-A1-102010 039 550
- DE-A1-102011 077 206
- DE-A1-102011 088 256
- US-A1- 2005 225 955
- US-A1- 2007 069 932

## Beschreibung

Die Erfindung betrifft eine mehrfunktionale Hochstromleiterplatte.

Aus dem Stand der Technik sind Hochstromleiterplatten bekannt. Hohe elektrische Ströme können in der Hochstromleiterplatte durch Stromleitungsschichten zu Leistungsschaltern geleitet werden. Die die Hochstromleiterplatten durchströmenden hohen Ströme verursachen elektromagnetische und/oder thermische Felder, die jeweils von einer stromführenden Schicht ausgehen. Diese Felder beeinträchtigen benachbarte Schichten der Hochstromleiterplatte, die beispielsweise zur Realisierung von Schaltsignalen oder zur Stromverteilung vorgesehen sind. Es ist nicht oder nur begrenzt möglich, die resultierenden Felder zumindest teilweise abzuschirmen. Aus diesem Grund sind Hochstromleiterplatten, bei welchen die Funktion der Leitung hoher Ströme mit der Funktion des Ansteuerns von Schaltungen für Leistungshalbleiter, insbesondere im Bereich der Feinstleitertechnik, vereint sind, nicht bekannt.

Aus WO 03/073812 A1 sind Hochstromleiterplatte bekannt umfassend mehrere Dicklagen aufweisende Stromleitungsschichten, eine Schaltschicht mit einem Leistungsschalter zum Schalten eines Verbrauchers, eine Ansteuerschicht mit einem Ansteuerelement zum Ansteuern eines Leistungsschalters und ein Abschirmelement zum Abschirmen der Stromleitungsschicht gegenüber der Ansteuerschicht und gegenüber der Schaltschicht.

Die Aufgabe der Erfindung besteht deshalb darin, eine mehrfunktionale Hochstromleiterplatte zu schaffen, die die Funktionen der Leitung hoher Ströme und des Ansteuerns von Schaltungen für Leistungshalbleiter vereint.

Zur Lösung dieser Aufgabe wird eine mehrfunktionale Hochstromleiterplatte entsprechend den Merkmalen des Patentanspruchs 1 angegeben. Die Hochstromleiterplatte umfasst eine mehrere Dicklagen aufweisende Stromleitungsschicht zum Leiten von elektrischem Strom, insbesondere von Hochstrom, der insbesondere mindestens mehrere 100 A, insbesondere mindestens 500 A und insbesondere mindestens 1000 A beträgt. Weiterhin umfasst die Hochstromleiterplatte eine mindestens einen Leistungsschalter zum Schalten eines mit der Hochstromleiterplatte verbindbaren Verbrauchers aufweisende Schaltschicht sowie eine mindestens ein Ansteuerelement aufweisende Ansteuerschicht zum Ansteuern des mindestens einen Leistungsschalters. Insbesondere sind die Schaltschicht, die Stromleitungsschicht und die Ansteuerschicht übereinander angeordnet, wobei die Stromleitungsschicht zwischen der Schaltschicht und der Ansteuerschicht angeordnet ist. Weiterhin umfasst die Hochstromleiterplatte mindestens ein Abschirmelement zum Abschirmen der Stromleitungsschicht gegenüber der Schaltschicht und gegenüber der Ansteuerschicht. Dadurch ist gewährleistet, dass hoher Strom durch die Stromleitungsschicht, die mehrere Dicklagen aufweist, geleitet werden kann, wobei durch den Stromfluss verursachte elektrische, magnetische und/oder thermische Felder von der mindestens einen Abschirmschicht zuverlässig abgeschirmt werden. Die Funktion der Schaltschicht, also das Schalten eines Verbrauchers, und die Funktion der Ansteuerschicht, also das Ansteuern des mindestens einen Leistungsschalters, werden durch den Stromfluss in der Stromleitungsschicht nicht beeinträchtigt. Die vorliegende Leiterplatte ermöglicht eine gezielte Abschirmung und Entkopplung der trennbaren Einzelfunktionen, nämlich Hochstromführung, Ansteuerung, Stromverteilung und Schaltung.

Vorteilhafte Ausgestaltungen der Hochstromleiterplatte ergeben sich aus den Merkmalen der von Anspruch 1 abhängigen Ansprüche.

Günstig ist eine Ausgestaltung, bei der die Stromleitungsschicht mindestens vier Dicklagen aufweist, wobei mindestens eine Stromhinleitungs-Dicklage zum Stromhinleiten von einer mit der Hochstromleiterplatte verbindbaren Spannungsquelle, insbesondere eine Batterie, über die Hochstromleiterplatte zu einem mit der Hochstromleiterplatte verbindbaren Verbraucher, insbesondere einem Elektromotor, und mindestens eine Stromrückleitungs-Dicklage zum Stromrückleiten von dem Verbraucher über die Hochstromleiterplatte zu der Spannungsquelle vorgesehen sind. Es ist auch möglich, dass mehr als vier Dicklagen vorgesehen sind. Insbesondere beträgt die Anzahl der Dicklagen m+n+2, wobei n die Anzahl der Stromhinleitungslagen, m die Anzahl der Rückleitungslagen beschreibt. Die 2 außenliegenden Dicklagen erfüllen zusätzlich Abschirmfunktionen. Insbesondere kann m ungleich n sein. Die Dicklagen ermöglichen eine Vergrößerung des Flächenanteils in der Stromleitungsschicht. Mögliche elektrische und/oder thermische Verluste in Folge des sogenannten Skin-Effekts, wonach Strom auf eine Leiteroberfläche verdrängt wird und somit den effektiven stromtragenden Querschnitt verkleinert, sind reduziert. Selbst steilflankige und hochfrequente Schaltvorgänge in dem mindestens einen Leistungsschalter führen nicht zu einer Erhöhung des elektrischen Leitungswiderstands. Der elektrische Leitungswiderstand ist nicht erhöht.

Besonders günstig ist eine Ausgestaltung, bei der die mindestens vier Dicklagen derart symmetrisch angeordnet sind, dass von den Dicklagen verursachte elektromagnetische Felder einander entgegengesetzt orientiert sind. Insbesondere kompensieren sich die von den Dicklagen verursachten elektromagnetischen Felder. Insbesondere kompensieren sich die elektromagnetischen Felder vollständig.

Besonders günstig ist eine Anordnung der vier Dicklagen derart, dass sie spiegelsymmetrisch zu einer virtuellen Mittenlage der Hochstromleiterplatte angeordnet sind. Beispielsweise ist jeweils benachbart zu der virtuellen Mittenlage eine Stromrückleitungs-Dicklage und jeweils eine durch die Stromhinleitungs-Dicklage von der virtuellen Mittenlage getrennte Stromleitungs-Dicklage vorgesehen. Aufgrund der symmetrischen Stromleitung können auch hohe Ströme effektiv in den Dicklagen geführt werden. Beispielsweise ist eine effektive Elimination zeitlich schnell veränderlicher magnetischer Felder in Folge einer Änderung der Stromstärke in Abhängigkeit der Zeit erreichbar.

Günstig ist eine Ausgestaltung, bei der die mindestens vier Dicklagen jeweils aus Kupfer bestehen und jeweils eine, insbesondere konstante Schichtdicke von etwa 105 µm bis maximal 400µm, insbesondere 105µm, 210µm oder 400 µm aufweisen. Durch derart ausgeführte Dicklagen kann ausreichend Strom geführt werden.

Gemäß der Erfindung weisen die mindestens zwei Stromhinleitungs-Dicklagen jeweils entlang einer leiterplatteninternen Stromleitungsrichtung eine veränderliche Dicklagen-Querschnittsfläche auf. Eine leiterplatteninterne Stromhinleitungsrichtung ist insbesondere von dem mindestens einen Ansteuerelement zu dem mindestens einen Leistungsschalter gerichtet. Eine leiterplatteninterne Stromrückleitungsrichtung ist insbesondere von dem mindestens einen Leistungsschalter zu dem mindestens einen Ansteuerelement gerichtet. Entlang der leiterplatteninternen Stromhinleitungsrichtung ist die Dicklagen-Querschnittsfläche zumindest abschnittsweise abnehmend ausgeführt. Entlang der leiterplatteninternen Stromrückleitungsrichtung ist die veränderliche Dicklagen-Querschnittsfläche zunehmend ausgeführt. Insbesondere führt die leiterplatteninterne Stromrückleitungsrichtung von dem mindestens einen Leistungsschalter zu dem mindestens einen Ansteuerelement. Dadurch ist eine geometrische Stromverteilung gewährleistet. Das bedeutet, dass eine leistungsgerechte und/oder leistungserforderliche Stromhinleitung zu den jeweiligen Leistungsschaltern und Stromrückleitung von den jeweiligen Leistungsschaltern möglich ist. Die jeweilige Dicklagen-Querschnittsfläche ist dem erforderlichen, durch die Dicklage zu führenden Strom angepasst. Das bedeutet, dass je höher der zu führende Strom in der Dicklage ist, desto größer ist die Dicklagen-Querschnittsfläche. Die Stromhinleitungs-Dicklagen sind an den jeweils damit verbundenen Leistungsschalter entsprechend angepasst. Die Dicklagen-Querschnittsfläche kann also dort gezielt reduziert werden, wo keine großen Ströme auftreten. Dadurch können zu groß dimensionierte Dicklagen-Querschnittsflächen vermieden werden. Zu groß dimensionierte Dicklagen-Querschnittsflächen erfordern einen erhöhten Platzbedarf. Die erfindungsgemäße Hochstromleiterplatte kann kleinbauend, kompakt ausgeführt sein. Gleichermaßen ist vermieden, dass die Dicklagen-Querschnittsfläche zu klein ist. Eine für die Stromleitung erforderliche Dicklagen-Querschnittsfläche ist gewährleistet. Dadurch können Verlustleistung und dadurch entstehende Wärmeentwicklung vermieden werden. Erfindungsgemäß wurde also erkannt, dass eine entlang der leiterplatteninternen Stromhinleitungsrichtung und/oder der leiterplatteninternen Stromrückleitungsrichtung konstante Dicklagen-Querschnittsfläche physikalisch überflüssig und unzutreffend ist. Vorteilhafterweise ist die Dicklagen-Querschnittsfläche entlang der leiterplatteninternen Stromhinleitungsrichtung und/oder der leiterplatteninternen Stromrückleitungsrichtung den jeweiligen Erfordernissen der Stromleitung angepasst. Die erfindungsgemäße Hochstromleiterplatte kann energieschonend betrieben werden.

Günstig ist eine Ausgestaltung mit einem ersten Abschirmelement zum Abschirmen der Stromleitungsschicht gegenüber der Schaltschicht und einem zweiten Abschirmelement zum Abschirmen der Stromleitungsschicht gegenüber der Ansteuerschicht. Dadurch ist eine zentrale Anordnung der Stromleitungsschicht zwischen der Schaltschicht und der Ansteuerschicht möglich. Eine derartige Hochstromleiterplatte ist robust ausgeführt.

Besonders günstig ist eine Ausgestaltung, bei der das erste Abschirmelement die der Schaltschicht benachbarte Dicklage der Stromleitungsschicht ist und/oder das zweite Abschirmelement die der Ansteuerschicht benachbarte Dicklage der Stromleitungsschicht ist. Insbesondere sind das erste Abschirmelement und das zweite Abschirmelement jeweils als Stromrückleitungs-Dicklagen ausgeführt. Die beiden in der Stromleitungsschicht außenliegenden Dicklagen dienen zur Abschirmung. Diese Dicklagen ermöglichen eine Funktionsintegration. Insbesondere ist es nicht erforderlich, separate Abschirmelemente in die Hochstromleiterplatte zu integrieren.

Vorteilhaft ist eine Ausgestaltung, bei der die Schaltschicht mindestens zwei Schaltschicht-Dünnlagen aufweist, wobei an einer, insbesondere außenliegenden, d.h. an einer Außenseite der Hochstromleiterplatte angeordneten, ersten Schaltschicht-Dünnlage der mindestens eine Leistungsschalter angebracht ist. Die erste Schaltschicht-Dünnlage ist mit einer, insbesondere innenliegenden, zweiten Schaltschicht-Dünnlage leitend verbunden. Insbesondere sind die erste Schaltschicht-Dünnlage und die zweite Schaltschicht-Dünnlage elektrisch und/oder thermisch leitend miteinander verbunden.

Besonders vorteilhaft ist eine Ausgestaltung derart, dass die mindestens zwei Schaltschicht-Dünnlagen durch mindestens eine Durchkontaktierung miteinander verbunden sind. Eine derartige Durchkontaktierung wird auch als Vertical Interconnect Access (VIA) bezeichnet. Die mindestens eine Durchkontaktierung kann als Mikro-VIA, insbesondere durch Laserbohren, hergestellt sein. Insbesondere ist die mindestens eine Durchkontaktierung mit Kupfer gefüllt. Eine derartige Durchkontaktierung wird auch als Mikro-VIA-Fill bezeichnet. Durch die Kupferfüllung ist der Kupferanteil der außenliegenden Schaltschicht-Dünnlagen erhöht. Die elektrische und thermische Verbindung zwischen den beiden Schaltschicht-Dünnlagen ist dadurch verbessert. Die in den Leistungsschaltern entstehende Wärme kann niederimpedant durch die beiden Schaltschicht-Dünnlagen geführt werden. Die entstehende Wärme kann also auf die beiden Schaltschicht-Dünnlagen aufgeteilt werden. Diese Aufteilung wird auch als Wärmespreizprinzip bezeichnet. Dadurch ist es möglich, auf konventionelle thermische Durchkontaktierungen zu verzichten oder zumindest die Anzahl von thermischen Durchkontaktierungen zu reduzieren. Die kupfergefüllten Durchkontaktierungen vergrößern eine Anbindungsfläche, über die die Hochstromleiterplatte mittels eines Wärmeleitmediums an einen Kühlkörper angebunden werden kann. Dadurch ist eine effektivere Kühlung der Hochstromleiterplatte, insbesondere der Leistungsschalter, möglich.

Vorteilhaft ist eine Ausgestaltung, bei die die Schaltschicht-Dünnlagen jeweils aus Kupfer bestehen und jeweils eine, insbesondere konstante, Schichtdicke von etwa 12 µm bis maximal 70 µm, insbesondere 12 µm, 18 µm, 35 µm oder 70 µm aufweisen. Die Dünnlagen sind unkompliziert und kostengünstig herstellbar. Die Dünnlagen sind an zu erwartende Anforderungen hinsichtlich der Stromleitung angepasst.

Vorteilhaft ist eine Ausgestaltung, bei der die Ansteuerschicht mindestens zwei Ansteuerschicht-Dünnlagen aufweist, wobei an einer, insbesondere außenliegenden, d.h. an einer Außenseite der Hochstromleiterplatte angeordneten, ersten Ansteuerschicht-Dünnlage das mindestens eine Ansteuerelement angebracht ist. Die erste Ansteuerschicht-Dünnlage ist mit einer, insbesondere innenliegenden, zweiten Ansteuerschicht-Dünnlage leitend verbunden. Insbesondere sind die Ansteuerschicht-Dünnlagen elektrisch und/oder thermisch leitend miteinander verbunden.

Besonderes vorteilhaft ist eine Ausgestaltung, bei der die mindestens zwei Ansteuerschicht-Dünnlagen durch mindestens eine Durchkontaktierung, insbesondere in Form eines lasergebohrten Mikro-VIA miteinander verbunden sind. Die mindestens eine Durchkontaktierung ist insbesondere hohl ausgeführt.

Sowohl die in den Patentansprüchen angegebenen Merkmale als auch die in dem nachfolgenden Ausführungsbeispiel der erfindungsgemäßen Hochstromleiterplatte angegebenen Merkmale sind jeweils für sich alleine oder in Kombination miteinander geeignet, den erfindungsgemäßen Gegenstand weiterzubilden. Die jeweiligen Merkmalskombinationen stellen hinsichtlich der Weiterbildungen des Erfindungsgegenstands keine Einschränkung dar, sondern weisen im Wesentlichen lediglich beispielhaften Charakter auf.

Weitere Merkmale, Vorteile und Einzelheiten der Erfindung ergeben sich aus der nachfolgenden Beschreibung eines Ausführungsbeispiels anhand der Zeichnung. Es zeigen:
- Fig. 1: eine schematische Darstellung einer elektrischen Schaltung mit einer erfindungsgemäßen Hochstromleiterplatte,
- Fig. 2: eine schematische Seitenansicht der Hochstromleiterplatte gemäß Fig. 1,
- Fig. 3: ein Fig. 2 entsprechender Längsschnitt durch die Hochstromleiterplatte und
- Fig. 4: eine funktional schematisierte Darstellung der Funktionsschichten der erfindungsgemäßen mehrfunktionalen Hochstromleiterplatte.

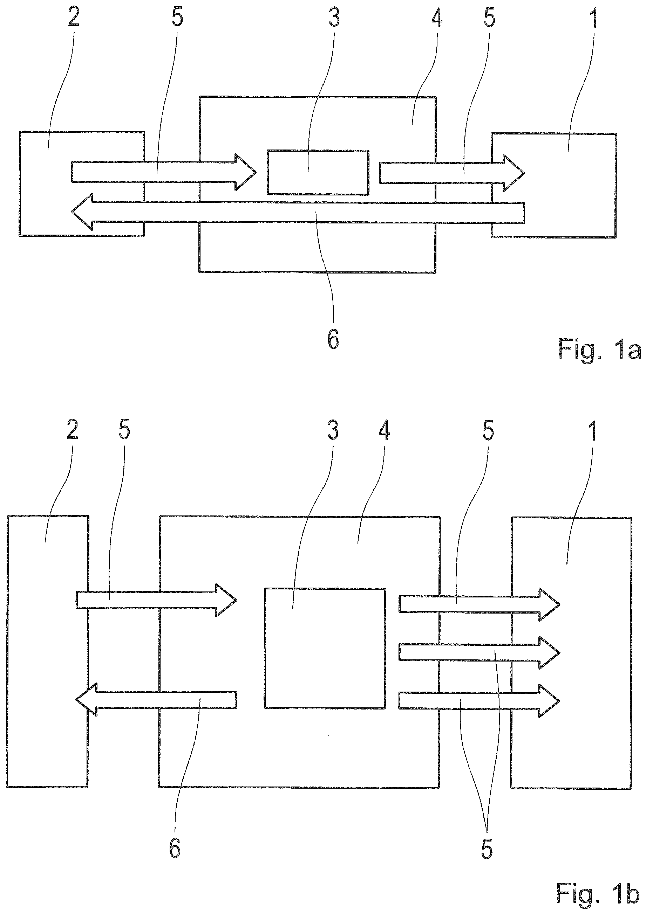

Einander entsprechende Teile sind in den Fig. 1 bis 4 mit denselben Bezugszeichen versehen. Auch Einzelheiten des im Folgenden näher erläuterten Ausführungsbeispiels können für sich genommen eine Erfindung darstellen oder Teil eines Erfindungsgegenstands sein.

Fig. 1a und Fig. 1b zeigen eine schematische Anordnung einer elektrischen Schaltung, bei der ein Verbraucher 1, insbesondere ein Elektromotor, von einer Spannungsquelle 2, insbesondere einer Batterie, mit elektrischer Spannung versorgt wird. Die Stromzufuhr von der Spannungsquelle 2 zu dem Verbraucher 1 erfolgt durch einen Schaltvorgang mittels mindestens eines Leistungsschalters 3 einer Hochstromleiterplatte 4. Eine Strom-Hinleitung 5 verbindet die Spannungsquelle 2 mit der Hochstromleiterplatte 4. Eine Strom-Rückleitung 6 verbindet den Verbraucher 1 über die Hochstromleiterplatte 4 mit der Spannungsquelle 2. Durch das Schließen des mindestens einen Leistungsschalters 3 wird ein Stromfluss von der Spannungsquelle 2 über den Leistungsschalter 3 zu dem Verbraucher 1 und wieder zurück ermöglicht. Auf der Hochstromleiterplatte 3 werden Stromhin- und rückführung bis zu einer Systemgrenze, z.B. Kontakt oder Stecker (nicht dargestellt) zur Verfügung gestellt.

Fig. 1 a zeigt, dass eine Strom-Hinleitung 5 die Hochstromleiterplatte 4 mit dem Verbraucher 1 verbindet. Fig. 1b zeigt, dass drei Strom-Hinleitungen 5 die Hochstromleiterplatte 4 mit dem Verbraucher, insbesondere einem 3-phasigen Verbraucher verbinden.

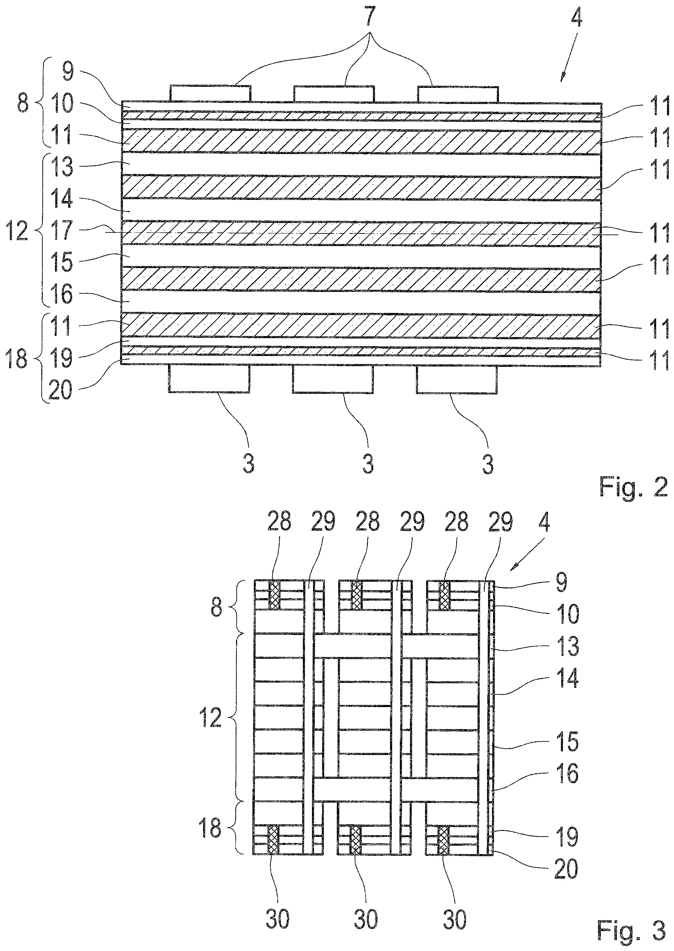

Fig. 2 zeigt den mehrlagigen Aufbau der Hochstromleiterplatte 4. Gemäß dem schematischen Beispiel in Fig. 2 sind an der Hochstromleiterplatte 4 drei Leistungsschalter 3 vorgesehen. Die Leistungsschalter 3 sind als Leistungshalbleiter ausgeführt. Insbesondere sind die Leistungsschalter 3 als eine spezialisierte Version eines Metall-Oxid-Halbleiter-Feldeffekttransistors ausgeführt, der auch als Leistungs-Mosfet bekannt ist. Die Leistungsschalter 3 sind gemäß der Darstellung in Fig. 2 an einer Unterseite der Hochstromleiterplatte 4 angeordnet.

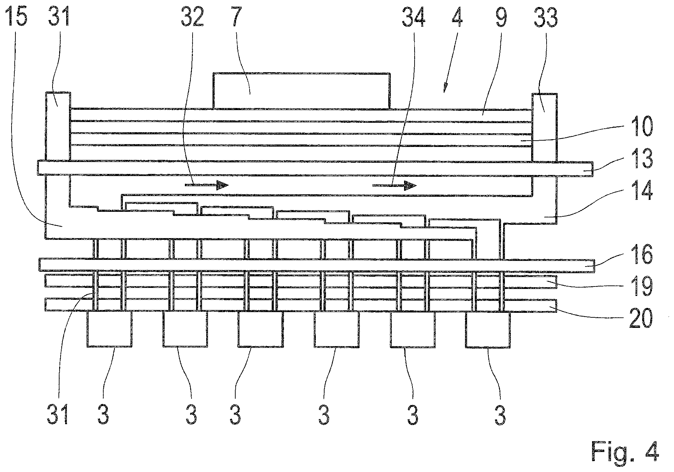

Die Hochstromsleiterplatte 4 weist mehrere Schichten auf, die jeweils verschiedene Funktionen erfüllen. Eine in Fig. 4 oben dargestellte Ansteuerschicht 8 umfasst zwei Ansteuerschicht-Dünnlagen 9, 10. An einer der Unterseite gegenüberliegenden Oberseite der Hochstromleiterplatte 4 sind drei Ansteuerelemente 7 vorgesehen. Die erste, an der Außenseite der Hochstromleiterplatte 4 angeordnete Ansteuerschicht-Dünnlage 9 trägt die Ansteuerelemente 7. Zwischen der ersten Ansteuerschicht-Dünnlage 9 und der zweiten Ansteuerschicht-Dünnlage 10 ist eine isolierende Kunststofflage 11 vorgesehen. Die Kunststofflage 11 dient zur Isolierung der elektrisch leitenden Lagen 9, 10. Die Kunststofflage 11 ist beispielsweise ein Kunststoffharz, insbesondere ein Epoxidharz. Die Ansteuerschicht-Dünnlagen 9, 10 bestehen beispielsweise aus Kupfer und weisen eine Schichtdicke von etwa 12µm, 18µm, 35 µm oder 70µm auf. An einer der ersten Ansteuerschicht-Dünnlage 9 abgewandten Unterseite der zweiten Ansteuerschicht-Dünnlage 10 ist eine weitere Kunststofflage 11 der Ansteuerschicht 8 vorgesehen.

An einer der Außenseite der Hochstromleiterplatte 4 gegenüberliegenden Seite der Ansteuerschicht 8 ist eine Stromleitungsschicht 12 vorgesehen. Die Stromleitungsschicht 12 umfasst vier Dicklagen 13, 14, 15 und 16, wobei jeweils zwei benachbarte Dicklagen 13 und 14, 14 und 15, 15 und 16 sowie 16 und 17 durch eine Kunststofflage 11 getrennt sind.

Die Dicklagen 13 bis 16 sind jeweils als Kupfer-Lagen ausgeführt und weisen eine Schichtdicke von etwa 105µm, 210 µm oder maximal 400µm auf. Die beiden innenliegenden Dicklagen 14, 15 sind als Stromhinleitungs-Dicklagen ausgeführt. Die Stromhinleitungs-Dicklagen 14, 15 sind mit den Strom-Hinleitungen 5 verbunden. Entsprechend sind die beiden außenliegenden Dicklagen 13, 16 als Stromrückleitungs-Dicklagen ausgeführt. Die Stromrückleitungs-Dicklagen 13, 16 sind mit der Strom-Rückleitung 6 verbunden. Die Stromhinleitungs-Dicklagen 14, 15 dienen zum leiterplatteninternen Stromhinleiten von den Ansteuerelementen 7 zu den Leistungsschaltern 3 und zurück. Die Stromhinleitungs-Dicklagen 14, 15 dienen zur Verbindung der Spannungsquelle 2 mit dem Verbraucher 1. Die Stromrückleitungs-Dicklagen 13, 16 dienen zum Stromrückleiten von dem Verbraucher 1 zu der Spannungsquelle 2 durch die Hochstrom-Leiterplatte 4. Die Stromleitungsschicht 12 ist achsensymmetrisch zu einer virtuellen Mittenlage 17 angeordnet. Die virtuelle Mittenlage 17 ist in Fig. 2 gestrichelt angedeutet. Die virtuelle Mittenlage 17 ist mittig in der zwischen den beiden Stromhinleitungs-Dicklagen 14, 15 angeordneten Kunststofflage 11 angeordnet.

An die Stromleitungsschicht 12 schließt sich eine Schaltschicht 18 an. Die Schaltschicht 18 umfasst zwei Kunststofflagen 11 und zwei Schaltschicht-Dünnlagen 19, 20, wobei an der ersten, außen angeordneten Schaltschicht-Dünnlage 20 die Leistungsschalter 3 angeordnet sind. Die Schaltschicht-Dünnlagen bestehen aus Kupfer und haben eine Schichtdicke von etwa 35 µm. Zwischen den beiden Schaltschicht-Dünnlagen 19, 20 ist eine Kunststofflage 11 vorgesehen.

Im Folgenden wird anhand der Fig. 3 die Verbindung der Lagen 9, 10, 13 bis 16, 19 und 20 näher erläutert. Die Fig. 3 stellt einen vergrößerten Ausschnitt eines Vertikalschnitts durch die Hochstromleiterplatte 4 im Bereich der in Fig. 6 links dargestellten Leistungsschalters 3 dar. Aus Fig. 3 geht hervor, dass jeweils die Ansteuerschicht-Dünnlagen 9, 10 der Ansteuerschicht 8 und jeweils die Schaltschicht-Dünnlagen 19, 20 der Schaltschicht 18 durch eine nicht durchgängige Durchkontaktierung 28 bzw. 30 miteinander verbunden sind. Die Durchkontaktierung, die auch als VIA bezeichnet wird, ist insbesondere eine Mikro-VIA und wird insbesondere durch Laserbohren hergestellt. Die Ansteuerschicht-Dünnlagen 9, 10 verbindende Mikro-VIA 28 ist hohl ausgeführt. Weiterhin sind durchgängige Durchkontaktierungen 29 vorgesehen, die die Hochstromleiterplatte 4 durch alle Lagen hinweg durchsetzt. Die Schaltschicht-Dünnlagen 19, 20 sind durch Mikro-VIA 33 miteinander verbunden. Die Mikro-VIA 30 sind im Wesentlichen analog den Mikro-VIA 28 ausgeführt, wobei die Mikro-VIA 30 mit Kupfer gefüllt sind. Die Durchkontaktierungen 30 werden auch als Mikro-VIA-Fill bezeichnet. Die innenliegenden Stromhinleitungs-Dicklagen 14, 15 dienen zur Stromhinleitung zu dem extern angebrachten Verbraucher 1. Die Stromhinleitungs-Dicklagen 14, 15 dienen als positiv geschaltene Potenzialflächen zur Stromversorgung in der Hochstromleiterplatte 4. Die Stromrückleitungs-Dicklagen 13, 16 dienen zur Stromrückleitung. Gleichzeitig sind die Stromrückleitungs-Dicklagen 13, 16 durchgehend ausgeführt und stellen ein erstes und ein zweites Abschirmelement zum Abschirmen der Stromleitungsschicht 12 gegenüber der Ansteuerschicht 8 und gegenüber der Schaltschicht 18 dar. Die Abschirmelemente 13, 16 sind also in der Stromleitungsschicht 12 integriert ausgeführt.

Die Leistungsschalter 3 ermöglichen eine Anbindung zu einer Wärmesenke beispielsweise einen Kühlkörper über Wärmeleitpasten oder Wärmeleitpads. Die Leistungsschalter 3 sind insbesondere durch hohe Stromänderungsraten pro Zeiteinheit gekennzeichnet. Derartige Stromwechsel sind aufgrund der Abschirmung der Stromleitungsschicht 12 unproblematisch. Insbesondere ist ein Skin-Effekt aufgrund einer erhöhten Dicklagen-Querschnittsfläche ausgeschlossen.

Im Folgenden wird anhand der Fig. 4 die Stromführung innerhalb der Hochstromleiterplatte 4 näher erläutert. Der wesentliche Aufbau der Hochstromleiterplatte 4 entspricht den vorherigen Darstellungen ist insbesondere in den Fig. 2 und 3 dargestellt. An einer Oberseite der Hochstromleiterplatte 4 ist ein Ansteuerelement 7 exemplarisch vorgesehen. Es können auch weitere Ansteuerelemente 7 an der ersten Ansteuerschicht-Dünnlage 9 vorgesehen sein.

An der Unterseite der Hochstromleiterplatte 4 sind die Leistungsschalter 3 an der ersten Schaltschicht-Dünnlage 20 angebracht. Eine Stromhinleitung von dem Ansteuerelement 7 zu den Leistungsschaltern 3 erfolgt über eine in Fig. 8 links an der ersten Ansteuerschicht-Dünnlage 9 angeordneten Stromhinleitung 31. Die Stromhinleitung 31 führt durch die Ansteuerschicht 8 mit den Ansteuerschicht-Dünnlagen 9, 10 und das erste Abschirmelement in Form der Stromrückleitungs-Dicklage 13 zu der Stromhinleitungs-Dicklage 15. Die Stromhinleitungs-Dicklage 15 gibt eine leiterplatteninterne Stromhinleitungsrichtung 32 vor. An einem links dargestellten Ende weist die Stromhinleitungs-Dicklage 15 eine maximale Dicklagenquerschnittsfläche auf. In diesem Bereich ist die Stromhinleitungs-Dicklage 15 geeignet, um maximalen Strom zu leiten. Ein zum Schalten des in Fig. 4 links dargestellten Leistungsschalters 3 erforderlicher Stromanteil wird über die Stromhinleitung durch die Stromrückleitungs-Dicklage 16 hindurch zu den Leistungsschaltern 3 geführt. Dieser abgezweigte Stromanteil muss im weiteren Verlauf entlang der Stromhinleitungsrichtung 32 nicht durch die Stromhinleitungs-Dicklage 15 geleitet werden. Entsprechend weist die Stromhinleitungs-Dicklage 15 nach der Abzweigung der Stromhinleitung 31 zu dem ersten Leistungsschalter 3 eine reduzierte Dicklagen-Querschnittsfläche auf. Insbesondere ist die Dicklagen-Querschnittsfläche der Stromhinleitungs-Dicklage 15 nach der Abzweigung der Stromhinleitung 31 um genau den Querschnittsanteil reduziert, der zum Leiten eines Stromanteils, der zur Versorgung des ersten Leistungsschalters 3 erforderlich ist, benötigt wird. Entlang der Stromhinleitungsrichtung 32 nimmt die Dicklagen-Querschnittsfläche der Stromhinleitungs-Dicklage 15 schrittweise ab. Wie in Fig. 4 dargestellt, weist die Stromhinleitungs-Dicklage eine treppenförmige Struktur entlang der Stromhinleitungsrichtung 32 auf. Es ist auch möglich, dass die Dicklagen-Querschnittsfläche entlang der Stromhinleitungs-Dicklage 15 kontinuierlich abnimmt, also rampenförmig ausgeführt ist.

Entsprechend nimmt die Dicklagen-Querschnittsfläche entlang einer leiterplatteninternen Stromrückleitungsrichtung 34 der Stromhinleitungs-Dicklage 14 zu. Die Stromhinleitungs-Dicklage 14 ist über eine Stromrückleitung 33 mit den Ansteuerschicht-Dünnlagen 9, 10 der Ansteuerschicht 8 verbunden.

Gemäß Fig. 4 sind sowohl die Stromhinleitungs-Dicklage 15 entlang der leiterplatteninternen Stromhinleitungsrichtung 20 und die Stromhinleitungs-Dicklage 15 entlang der leiterplatteninternen Stromrückleitungsrichtung 34 jeweils treppenförmig, also stufenweise veränderlich bezüglich der Dicklagen-Querschnittsfläche ausgeführt. Insbesondere sind die Stromhinleitungs-Dicklagen 14, 15 derart ausgeführt und in der Hochstromleiterplatte 4, insbesondere in der Stromleitungsschicht 12 angeordnet, dass eine Gesamt-Dicklagen-Querschnittsfläche, die der Summe der Dicklagen-Querschnittsflächen der Stromhinleitungs-Dicklagen 14, 15 entspricht, entlang der Stromleitungsrichtungen 32, 34 im Wesentlichen konstant ist. Dies wird insbesondere dadurch ermöglicht, dass in dem Maße, in dem die Dicklagen-Querschnittsfläche der Stromhinleitungs-Dicklage 15 schrittweise abnimmt, die Dicklagen-Querschnittsfläche der Stromhinleitungs-Dicklage 14 schrittweise zunimmt. Dadurch ist es möglich, die beiden Stromhinleitungs-Dicklagen 14, 15 besonders platzsparend und kompakt in der Hochstromleiterplatte 4 anzuordnen.

Unter der Voraussetzung, dass der Strombedarf für die einzelnen Leistungsschalter 3 jeweils identisch ist, beträgt die maximale Dicklagen-Querschnittsfläche die Summe der einzelnen Querschnittsflächen, die für die Leitung des Einzelstroms erforderlich sind.

### Bezugszeichen

- 1: Verbraucher
- 2: Spannungsquelle
- 3: Leistungsschalter
- 4: Hochstromleiterplatte
- 5: Strom-Hinleitung
- 6: Strom-Rückleitung
- 7: Ansteuerelement
- 8: Ansteuerschicht
- 9: erste Ansteuerschicht-Dünnlage
- 10: zweite Ansteuerschicht-Dünnlage
- 11: Kunststofflage
- 12: Stromleitungsschicht
- 13: Stromrückleitungs-Dicklage
- 14: Stromhinleitungs-Dicklage
- 15: Stromhinleitungs-Dicklage
- 16: Stromrückleitungs-Dicklage
- 17: virtuelle Mittenlage
- 18: Schaltschicht
- 19: zweite Schaltschicht-Dünnlage
- 20: erste Schaltschicht-Dünnlage
- 21: Kupfer-Unterlage
- 22: erste Durchkontaktierung
- 23: zweite Durchkontaktierung
- 24: Zwischenkreis-Kondensator
- 25: Zufluss-Element
- 26: Abfluss-Element
- 27: Steuerelektrode
- 28: Mikro-VIA zwischen Ansteuerschicht-Dünnlagen 9, 10
- 29: Durchkontaktierung
- 30: Mikro-VIA-Fill zwischen Schaltschicht-Dünnlagen 20, 19
- 31: Stromhinleitung
- 32: Leiterplatteninterne Stromhinleitungsrichtung
- 33: Stromrückleitung
- 34: Leiterplatteninterne Stromrückleitungsrichtung

## Patentansprüche

1. Mehrfunktionale Hochstromleiterplatte (4) umfassend
a. eine mehrere Dicklagen (13, 14, 15, 16) aufweisende Stromleitungsschicht (12) zum Leiten von elektrischem Strom,
b. eine mindestens einen Leistungsschalter (3) zum Schalten eines Verbrauchers (1) aufweisende Schaltschicht (18),
c. eine mindestens ein Ansteuerelement (7) aufweisende Ansteuerschicht (8) zum Ansteuern des mindestens einen Leistungsschalters (7),
d. mindestens ein Abschirmelement (13, 16) zum Abschirmen der Stromleitungsschicht (12) gegenüber der Ansteuerschicht (8) und gegenüber der Schaltschicht (18)
**dadurch gekennzeichnet, dass** die mindestens eine Stromhinleitungs-Dicklage (14, 15) und Stromrückleitungs-Dicklage (13, 16) jeweils entlang einer leiterplatteninternen Stromleitungsrichtung (32, 34) eine zumindest abschnittsweise veränderliche Dicklagen-Querschnittsfläche aufweisen.

2. Hochstromleiterplatte (4) nach Anspruch 1, **dadurch gekennzeichnet, dass** die Stromleitungsschicht (12) mindestens vier Dicklagen (13, 14, 15, 16) aufweist, wobei mindestens eine Stromhinleitungs-Dicklage (14, 15) zum Stromhinleiten von einer mit der Hochstromleiterplatte (4) verbindbaren Spannungsquelle (2) über die Hochstromleiterplatte (4) zu einem mit der Hochstromleiterplatte (4) verbindbaren Verbraucher (1) und mindestens eine Stromrückleitungs-Dicklage (13, 16) zum Stromrückleiten von dem Verbraucher (1) über die Hochstromleiterplatte (4) zu der Spannungsquelle (2) vorgesehen sind.

3. Hochstromleiterplatte (4) nach Anspruch 2, **dadurch gekennzeichnet, dass** die mindestens vier Dicklagen (13, 14, 15, 16) derart symmetrisch angeordnet sind, dass von den Dicklagen (13, 14, 15, 16) verursachte elektromagnetische Felder einander entgegengesetzt gerichtet sind und sich insbesondere kompensieren.

4. Hochstromleiterplatte (4) nach Anspruch 2 oder 3, **dadurch gekennzeichnet, dass** die Stromleitungsschicht (12) alternierend aus Stromhinleitungs-Dicklagen (14, 15) und Stromrückleitungs-Dicklagen (13, 16) aufgebaut sind.

5. Hochstromleiterplatte (4) nach einem der vorstehenden Ansprüche, **dadurch gekennzeichnet, dass** die mindestens vier Dicklagen (13, 14, 15, 16) jeweils aus Kupfer bestehen und jeweils eine, insbesondere konstante Schichtdicke von etwa 105 µm bis maximal 400µm, insbesondere 105µm, 210µm oder 400 µm aufweisen.

6. Hochstromleiterplatte (4) nach einem der vorstehenden Ansprüche, **gekennzeichnet durch** ein erstes Abschirmelement (16) zum Abschirmen der Stromleitungsschicht (12) gegenüber der Schaltschicht (18) und ein zweites Abschirmelement (13) zum Abschirmen der Stromleitungsschicht (12) gegenüber der Ansteuerschicht (8).

7. Hochstromleiterplatte (4) nach Anspruch 6, **dadurch gekennzeichnet, dass** das erste Abschirmelement die der Schaltschicht (18) benachbarte Dicklage (16) der Stromleitungsschicht (12) und das zweite Abschirmelement die der Ansteuerschicht (8) benachbarte Dicklage (13) der Stromleitungsschicht (12) ist.

8. Hochstromleiterplatte (4) nach einem der vorstehenden Ansprüche, **dadurch gekennzeichnet, dass** die Schaltschicht (18) mindestens zwei Schaltschicht-Dünnlagen (19, 20) aufweist, wobei an einer ersten Schaltschicht-Dünnlage (20) der mindestens eine Leistungsschalter (3) angebracht ist und wobei die erste Schaltschicht-Dünnlage (20) mit einer zweiten Schaltschicht-Dünnlage (19) leitend verbunden ist.

9. Hochstromleiterplatte (4) nach Anspruch 8, **dadurch gekennzeichnet, dass** die mindestens zwei Schaltschicht-Dünnlagen (19, 20) durch mindestens eine Durchkontaktierung (23, 29, 30) verbunden sind, wobei die mindestens eine Durchkontaktierung (30) insbesondere mit Kupfer gefüllt ist.

10. Hochstromleiterplatte (4) nach einem der Ansprüche 8 oder 9, **dadurch gekennzeichnet, dass** die Schaltschicht-Dünnlagen (19, 20) jeweils aus Kupfer bestehen und jeweils eine, insbesondere konstante, Schichtdicke von etwa 12 µm bis maximal 70 µm, insbesondere 12 µm, 18 µm, 35 µm oder 70 µm aufweisen.

11. Hochstromleiterplatte (4) nach einem der vorstehenden Ansprüche, **dadurch gekennzeichnet, dass** die Ansteuerschicht (8) mindestens zwei Ansteuerschicht-Dünnlagen (9, 10) aufweist, wobei an einer ersten Ansteuerschicht-Dünnlage (9) das mindestens eine Ansteuerelement (7) angebracht ist und wobei die erste Ansteuerschicht-Dünnlage (9) mit einer zweiten Ansteuerschicht-Dünnlage (10) leitend verbunden ist.

12. Hochstromleiterplatte (4) nach Anspruch 11, **dadurch gekennzeichnet, dass** die mindestens zwei Ansteuerschicht-Dünnlagen (9, 10) durch mindestens eine Durchkontaktierung (22, 28, 29) verbunden sind, wobei die mindestens eine Durchkontaktierung (28) insbesondere hohl ausgeführt ist.

13. Hochstromleiterplatte (4) nach einem der Ansprüche 11 oder 12, **dadurch gekennzeichnet, dass** die Ansteuerschicht-Dünnlagen (9, 10) jeweils aus Kupfer bestehen und jeweils eine, insbesondere konstante, Schichtdicke von etwa 12 µm bis maximal 70 µm, insbesondere 12 µm, 18 µm, 35 µm oder 70 µm aufweisen.

## Claims

1. Multifunctional high-current circuit board (4), comprising
a. a current-conducting layer (12) which has multiple thick plies (13, 14, 15, 16) and which serves for conducting electrical current,
b. a switching layer (18) which has at least one power switch (3) for the switching of a consumer (1),
c. an actuation layer (8) which has at least one actuation element (7) and which serves for the actuation of the at least one power switch (7),
d. at least one shielding element (13, 16) for shielding the current-conducting layer (12) with respect to the actuation layer (8) and with respect to the switching layer (18),
**characterized in that** the at least one current-feed thick ply (14, 15) and current return thick ply (13, 16) have, in each case along a circuit-board-internal current-conducting direction (32, 34), a thick ply cross-sectional area which varies at least in sections.

2. High-current circuit board (4) according to Claim 1, **characterized in that** the current-conducting layer (12) has at least four thick plies (13, 14, 15, 16), wherein at least one current-feed thick ply (14, 15) for the feed of current from a voltage source (2) which is connectable to the high-voltage circuit board (4) via the high-current circuit board (4) to a consumer (1) which is connectable to the high-current circuit board (4), and at least one current-return thick ply (13, 16) for the return of current from the consumer (1) via the high-current circuit board (4) to the voltage source (2), are provided.

3. High-current circuit board (4) according to Claim 2, **characterized in that** at least four thick plies (13, 14, 15, 16) are arranged symmetrically such that electromagnetic fields generated by the thick plies (13, 14, 15, 16) are directed oppositely to one another and in particular compensate one another.

4. High-current circuit board (4) according to Claim 2 or 3, **characterized in that** the current-conducting layer (12) is constructed from current-feed thick plies (14, 15) and current-return thick plies (13, 16) in alternation.

5. High-current circuit board (4) according to one of the preceding claims, **characterized in that** the at least four thick plies (13, 14, 15, 16) are each composed of copper and each have an in particular constant layer thickness from approximately 105 µm to at most 400 µm, in particular of 105 µm, 210 µm or 400 µm.

6. High-current circuit board (4) according to one of the preceding claims, **characterized by** a first shielding element (16) for shielding the current-conducting layer (12) with respect to the switching layer (18) and a second shielding element (13) for shielding the current-conducting layer (12) with respect to the actuation layer (8).

7. High-current circuit board (4) according to Claim 6, **characterized in that** the first shielding element is that thick ply (16) of the current-conducting layer (12) which is adjacent to the switching layer (18), and the second shielding element is that thick ply (13) of the current-conducting layer (12) which is adjacent to the actuation layer (8).

8. High-current circuit board (4) according to one of the preceding claims, **characterized in that** the switching layer (18) has at least two switching-layer thin plies (19, 20), wherein the at least one power switch (3) is attached to a first switching-layer thin ply (20), and wherein the first switching-layer thin ply (20) is connected in conductive fashion to a second switching-layer thin ply (19).

9. High-current circuit board (4) according to Claim 8, **characterized in that** the at least two switching-layer thin plies (19, 20) are connected by means of at least one feedthrough (23, 29, 30), wherein the at least one feedthrough (30) is in particular filled with copper.

10. High-current circuit board (4) according to either of Claims 8 and 9, **characterized in that** the switching-layer thin plies (19, 20) are each composed of copper and each have an in particular constant layer thickness from approximately 12 µm to at most 70 µm, in particular of 12 µm, 18 µm, 35 µm or 70 µm.

11. High-current circuit board (4) according to one of the preceding claims, **characterized in that** the actuation layer (8) has at least two actuation-layer thin plies (9, 10), wherein the at least one actuation element (7) is attached to a first actuation-layer thin ply (9), and wherein the first actuation-layer thin ply (9) is connected in conductive fashion to a second actuation-layer thin ply (10).

12. High-current circuit board (4) according to Claim 11, **characterized in that** the at least two actuation-layer thin plies (9, 10) are connected by means of at least one feedthrough (22, 28, 29), wherein the at least one feedthrough (28) is in particular of hollow form.

13. High-current circuit board (4) according to either of Claims 11 and 12, **characterized in that** the actuation-layer thin plies (9, 10) are each composed of copper and each have an in particular constant layer thickness from approximately 12 µm to at most 70 µm, in particular of 12 µm, 18 µm, 35 µm or 70 um.

## Revendications

1. Carte de circuit imprimé multifonctionnelle pour courant fort (4), comprenant
a. une couche électroconductrice (12) comprenant plusieurs couches épaisses (13, 14, 15, 16) et destinée à conduire un courant électrique,
b. une couche de commutation (18) comportant au moins un commutateur de puissance (3) destiné à commuter une charge (1),
c. une couche de commande (8) comportant au moins un élément de commande (7) et destinée à commander l'au moins un commutateur de puissance (7),
d. au moins un élément de blindage (13, 16) destiné à blinder la couche électroconductrice (12) par rapport à la couche de commande (8) et par rapport à la couche de commutation (18),
**caractérisée en ce que** l'au moins une couche épaisse électroconductrice (14, 15) et l'au moins une couche épaisse de retour de courant (13, 16), respectivement suivant une direction de conduction de courant (32, 34) interne à la carte de circuit imprimé, présentent une surface de section transversale des couches épaisses qui peut être modifiée au moins par endroits.

2. Carte de circuit imprimé pour courant fort (4) selon la revendication 1, **caractérisée en ce que** la couche électroconductrice (12) comporte au moins quatre couches épaisses (13, 14, 15, 16), dans laquelle au moins une couche épaisse électroconductrice (14, 15) est prévue pour injecter, par l'intermédiaire de la carte de circuit imprimé pour courant fort (4) un courant depuis une source de tension (2) pouvant être connectée à la carte de circuit imprimé pour courant fort (4) vers une charge (1) pouvant être connectée à la carte de circuit imprimé pour courant fort (4) et au moins une couche épaisse de retour de courant (13, 16) permettant d'acheminer un retour de courant depuis la charge (1), par l'intermédiaire de la carte de circuit imprimé pour courant fort (4), vers la source de tension (2).

3. Carte de circuit imprimé pour courant fort (4) selon la revendication 2, **caractérisée en ce que** les au moins quatre couches épaisses (13, 14, 15, 16) sont agencées symétriquement de manière à ce que des champs électromagnétiques produits par les couches épaisses (13, 14, 15, 16) soient orientés de manière opposée les uns aux autres et notamment, se compensent.

4. Carte de circuit imprimé pour courant fort (4) selon la revendication 2 ou 3, **caractérisée en ce que** la couche électroconductrice (12) est constituée en alternance de couches épaisses électroconductrices (14, 15) et de couches épaisses de retour de courant (13, 16).

5. Carte de circuit imprimé pour courant fort (4) selon l'une quelconque des revendications précédentes, **caractérisée en ce que** les au moins quatre couches épaisses (13, 14, 15, 16) sont respectivement constituées de cuivre et présentent respectivement une épaisseur de couche, notamment constante, d'environ 105 µm jusqu'à un maximum de 400 µm, notamment de 105 µm, 210 µm, ou 400 µm.

6. Carte de circuit imprimé pour courant fort (4) selon l'une quelconque des revendications précédentes, **caractérisée par** un premier élément de blindage (16) destiné à blinder la couche électroconductrice (12) par rapport à la couche de commutation (18) et par un deuxième élément de blindage (13) destiné à blinder la couche électroconductrice (12) par rapport à la couche de commande (8).

7. Carte de circuit imprimé pour courant fort (4) selon la revendication 6, **caractérisée en ce que** le premier élément de blindage est la couche épaisse (16) adjacente à la couche de commutation (18) de la couche électroconductrice (12) et **en ce que** le deuxième élément de blindage est la couche épaisse (13) adjacente à la couche de commande (8) de la couche électroconductrice (12).

8. Carte de circuit imprimé pour courant fort (4) selon l'une quelconque des revendications précédentes, **caractérisée en ce que** la couche de commutation (18) comporte au moins deux couches minces de couches de commutation (19, 20), dans laquelle l'au moins un commutateur de puissance (3) est monté sur une première couche mince des couches de commutation (20) et dans laquelle la première couche mince des couches de commutation (20) est reliée de manière conductrice à une deuxième couche mince des couches de commutation (19).

9. Carte de circuit imprimé pour courant fort (4) selon la revendication 8, **caractérisée en ce que** les au moins deux couches minces des couches de commutation (19, 20) sont reliées par l'intermédiaire d'au moins une métallisation traversante (23, 29, 30), dans laquelle l'au moins une métallisation traversante (30) est notamment remplie de cuivre.

10. Carte de circuit imprimé pour courant fort (4) selon l'une quelconque des revendications 8 ou 9, **caractérisée en ce que** les couches minces des couches de commutation (19, 20) sont respectivement constituées de cuivre est présentent respectivement une épaisseur de couche, notamment constante, d'environ 12 µm jusqu'à un maximum de 70 µm, notamment de 12 µm, 18 µm, 35 µm ou 70 µm.

11. Carte de circuit imprimé pour courant fort (4) selon l'une quelconque des revendications précédentes, **caractérisée en ce que** la couche de commande (8) comporte au moins deux couches minces de couches de commande (9, 10), dans laquelle l'au moins un élément de commande (7) est monté sur une première couche mince des couches de commande (9) et dans laquelle la première couche mince des couches de commande (9) est reliée de manière conductrice à une deuxième couche mince des couches de commande (10).

12. Carte de circuit imprimé pour courant fort (4) selon la revendication 11, **caractérisée en ce que** les au moins deux couches minces des couches de commande (9, 10) sont reliées par l'intermédiaire d'au moins une métallisation traversante (22, 28, 29), dans laquelle l'au moins une métallisation traversante (28) est notamment réalisée de manière à être creuse.

13. Carte de circuit imprimé pour courant fort (4) selon l'une quelconque des revendications 11 ou 12, **caractérisée en ce que** les couches minces des couches de commande (9, 10) sont respectivement constituées de cuivre et présentent respectivement une épaisseur de couche, notamment constante, d'environ 12 µm jusqu'à un maximum de 70 µm, notamment de 12 µm, 18 µm, 35 µm ou 70 µm.
